(19) Europäisches Patentamt
European Patent Office
Office européen des brevets

(11) Publication number: **0 194 152 B1**

(12) # EUROPEAN PATENT SPECIFICATION

(45) Date of publication of patent specification: **13.03.91** (51) Int. Cl.5: **H05K 3/34**

(21) Application number: **86301611.9**

(22) Date of filing: **06.03.86**

The file contains technical information submitted after the application was filed and not included in this specification

(54) **Soldering electronic components on a support.**

(30) Priority: **06.03.85 IT 1979085**

(43) Date of publication of application:
**10.09.86 Bulletin 86/37**

(45) Publication of the grant of the patent:
**13.03.91 Bulletin 91/11**

(84) Designated Contracting States:
**BE DE FR GB NL SE**

(56) References cited:
**GB-A- 2 139 132**
**US-A- 3 665 041**
**US-A- 3 866 307**
**US-A- 4 032 033**

**R.J.KLEIN WASSINIK; "Soldering in Electronics", 1984, ELECTROCHEMICAL PUBLICATIONS LTD., (Scotland)**

**WELDING RESEARCH, vol. 39, no. 1, November 1984, New Jersey; D.SCHOENTHALER, "Solder Fusing with Heated Liquids"**

**G. Colombo, "Manuale dell'Ingegnere Civile e Industriale", 80th edition, Ulrico Hoepli, Milan 1950, p. 129**

(73) Proprietor: **Montedison S.p.A.**
**31, Foro Buonaparte**
**I-20121 Milan(IT)**

(72) Inventor: **Johns, Ken**
**62, School Road**
**Ashford Middlesex(GB)**
Inventor: **Briggs, Stuart**
**92, Church Road**
**Richmond Surrey(GB)**
Inventor: **Flabbi, Luciano**
**45, via Spezia**
**I-20142 Milan(IT)**

(74) Representative: **Whalley, Kevin et al**
**MARKS & CLERK 57/60 Lincoln's Inn Fields**
**London WC2A 3LS(GB)**

**EP 0 194 152 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The present invention in general concerns a process for the carrying out of the soldering of manufactured articles by means of suitable soldering materials, wherever there is a requirement for application of heat with a gradual and controlled increase of the temperature. More particularly, this invention relates to a process for the soldering of electronic components on a support, by means of such soldering materials.

Various methods are presently in use for soldering electronic components on suitable supports. One of these methods concerns mainly the soldering of devices/components mounted on the support with their connections passing through metallized holes piercing the support itself.

According to this method, the lower part of the support, opposite to that on which the components are mounted, is wetted by a wave of molten metal, in general a tin-lead alloy, which penetrates the metallized holes of the support and coats a metallized area around the connection of the device. When the supporting plate is withdrawn from the metal wave, the metal deposited on the support, while cooling down, solidifies and thus connects the components with the support. This method, known as "WAVE SOLDERING", displays, however, some well-known drawbacks (described for example in the article entitled: "Technique for soldering surface mounted devices (SMD) to Printed Circuit Boards (PCB)" by C.J. Brierley et al., which appeared in Brazing and Soldering, Autumn 1984), in the case in which the components are mounted on the surface of the support ('surface mounted devices' - SMD), without making recourse to holes but by simply placing the components on one or both faces of the support and glueing them there.

In the case of components mounted on the surface (SMD) a second system may be used, which consists in mounting the SMD on the support in the desired position on suitable metallized traces obtained by putting on the support a suitable soldering cream.

The assembly is then heated up by conduction, convention, or radiation, or a combination of the three ways, by means of a suitable system, for instance by means of hot air, infrared rays, or the saturated vapour of an inert substance, so as to reflow the soldering cream which, successively cooling down, will ensure the mechanical-electrical connection between the components and the support. The system which uses the saturated vapour is presently known as one of the most effective for the soldering of SMD by solder reflow and it consists in immersing the assembly in a saturated vapour of an inert fluid, usually perfluoro-carbides. In this case use is made of the latent heat of the vapours which condense on the assembly, reflowing the soldering material (vapour phase soldering - VPS). This method is described in a number of articles and patents, amongst which may, for instance, be cited GB-A-2,139,132 and US-A-3,866,307.

However, VPS shows certain drawbacks, amongst which the most important is the fact that the operational temperature is one sole temperature, since it is fixed by the boiling temperature of the fluid. This limits the choice of the soldering alloys to those whose liquidus is below the boiling temperature of the fluid.

Also known in the art, see for example "Solder fusing with heated fluids" by D. Schoenthaler in Welding Research Supplement, November 1974, is the possibility of immersing the articles in hot fluids, such as for instance glycerin, polyglycols, fluorinated oxypropylenes, polychlorotrifluoroethylene, polyphenyl ethers, and mineral and vegetable oils, generally in mere finishing operations on printed circuits. For example for rounding (by reflowing them) tin-lead residues or other metal alloy residues left over by previous operations (for instance in operations of electro-deposition) and not cleanly cut, or in operations of homogenization of the product or for the manufacture of the electrical infraconnections to the supports. However, the use of such fluids creates a number of different problems and, thus, it is not advisable to generalize their use for more important applications such as real and proper soldering.

The main drawback in the use of fluorinated oxypropylenes lies in the alteration of the angle of contact following their prolonged use, with the consequential worsening of soldering. Polychlorotrifluoroethylenes, following prolonged use, generate hydrolytically unstable compounds and yield liquid cleavage products with a lower molecular weight and with too low viscosity and boiling point. Moreover, the polychlorotrifluoroethylenes used in the cited technique must necessarily possess boiling points well above the melt points of the soldering alloys in order to avoid losses due to evaporation, besides the losses due to compensation. This means that one should use polychlorotrifluoroethylenes with a relatively high molecular weight, which consequently, although having a low vapour pressure, have a high viscosity. This means that the pieces coming out of the bath would remove, by drag-out, exaggerately high quantities of fluid.

As far as the other fluids are concerned, these are in their totality inflammable or insufficiently stable under conditions of use, that is, in contact with the air. So much so, that sometimes vegetable oil is placed over a bath of molten metal, because in this way the oil, reacting with the atmospheric oxygen, will protect

the underlying metal from oxidation. As is well known, in fact, soldering shows better properties when the metal does not come into contact with oxygen.

We have now found a soldering method that overcomes all the afore-mentioned drawbacks.

Accordingly, the invention provides a process for soldering electronic components to a support, the process comprising arranging the components on the support together with a soldering material, and then placing the thus obtained assembly in contact with a perfluoropolyether which is in the liquid state and which has a temperature equal to or greater than the temperature at which the soldering material develops its binding properties.

The components may be mounted on the support in any required position, whether on the surface, also on both faces of the support, or through metallized holes made in the support itself, where they may be kept in position by the soldering material (e.g. a cream or paste) endowed with binding properties, deposited on the surface or previously inserted into the metallized holes of the support. The binding properties of the soldering material are subsequently developed by the heating obtained by the contact of one or both surfaces of the support with the perfluoropolyether in the liquid state.

Perfluoropolyethers are products well known in the art. Their preparation will be found described in numerous patents, such as for example: in GB-A-1104482, 1153306, 1189337, and 1217871, in US-A-3242218, 3665041, and 3715378, and in Italian Patent Application 19496 A/85. There may be used, in the soldering process of the invention, perfluoropolyethers with kinematic viscosity values, at a temperature of 20 °C, comprised between 10 and 2000 cSt, and which, moreover, are non-boiling at atmospheric pressure and show a loss by evaporation of less than 1% by weight at a temperature of 150 °C (measured according to ASTM D 976/56 standards).

The suitability of the perfluoropolyethers for soldering in liquid phase proves to be surprising also for the fact that such compounds are permeable to oxygen, wherefore it would be feared that there would be a tendency towards oxidation of the molten metal, just as described previously.

Preferred perfluoropolyethers for the soldering process of the invention are those of the general structure:

$$(I)\quad CF_3-(O-\underset{\substack{|\\ CF_3}}{CF}-CF_2)_n-(O-CF_2)_m-O-CF_3$$

wherein: $n$ is a number between 5 and 50, while $m$ is a number such that the ratio n/m is between 10 and 50.

Other suitable perfluoropolyethers are, in particular, those belonging to the following classes: (II) $C_3F_7O-(C_3F_6O)_m-R_f$,
wherein $R_f$ may be: $-C_2F_5$, $-C_3F_7$, or $-CFHCF_3$,
while $m$ is an integer.
(III) $CF_3O(C_3F_6O)_m(C_2F_4O)_n(CFXO)_q-CF_3$,
wherein:
X is equal either to -F or to $-CF_3$: $m$ $n$ , and $q$ are integers whose sum is between 10 and 300: n/q = 0.5 to 5: m/(q+n) = 0.01 to 0.4.
(IV) $CF_3O(C_2F_4O)_p(CF_2O)_q-CF_3$, wherein:
$p$ and $q$ are integers equal to or different from each other, and where the ratio p/q is between 0.5 and 1.5.
(V) $R_F(OCF_2CF_2CF_2)_n-OR_F$, wherein:
$R_F$ is F, perfluoroalkyl, perfluoro-oxyalkyl, or perfluoropolyoxyalkyl.
(VI) Perfluoropolyethers of oxetanic structure, as described in Ital. Pat. Appl. Nr. 19496 A/85.

The temperatures at which the process according to the present invention is conducted must be at least equal to the temperature at which soldering materials present on the support develop their binding properties through heating.

As soldering materials there may be used all those used in the soldering processes, and consisting of a soldering metal or alloy or of a soldering metal or alloy incorporated in suitable fluxes, de-oxidizers, and various additives, inclusive of solvents such as isopropanol.

Examples of such metals and alloys are: tin; tin-lead alloys (for instance those with ratios Sn/Pb = 63/37: 60/40: 50/50): tin/silver alloys (e.g. : with ratios Sn/Ag = 96.5 /3.5; 95/5); tin/antimony alloys (95/5, 99/1); tin/lead/silver alloys (62/36/2); cadmium/tin alloys; etc.; generally with liquidus temperatures between 180 °C and 250 °C.

The binding action of such soldering materials develops through the melting and successive cooling

down of the material.

Fluxes have, as is well known to those skilled in the art, two specific functions. The first is that of removing the oxidized film coating the metal soldering materials. The second function is that of helping heat transfer during the soldering operation. As fluxes there are used in general weak acids, such as for example rosin (colophony) and other resinous acids, or organic salts such as methylammonium chloride.

Likewise there may be used soldering materials of a non-metallic type, electrically conductive, provided they are capable of exerting a binding action through the heating and cooling cycle. Examples of such materials are represented by epoxy and acrylic resins capable of exerting the binding action through vulcanization.

The support for the electronic components may be constituted by different materials such as for instance glass fibres impregnated with epoxy or phenolic resins: plastics laminates based on epoxy or phenolic resins: ceramic materials consisting of sintered alumina powders: or metallic materials or plastic materials in general.

The process of this invention may be applied independently from the method of tracing the electrical connections among the various different components which are to be connected, and independently from the method by which the soldering material is applied.

Preferably, the electronic components are mounted onto the surface of the support on metallized traces made of soldering materials (e.g. creams) or of other pre-deposited conductive materials, or are inserted either through metallized holes filled with soldering cream or through holes into which preformed soldering pastes have been inserted.

The contact between the support and the liquid perfluoropolyether, according to the process of the present invention, may be achieved in various different ways. Amongst these, just for exemplifying purposes, there may be cited:

- the skimming of the undersurface of the support by a wave of liquid:
- the crossing by the support of a wave of liquid, with the consequential contact on both surfaces of the support with the liquid;
- the immersion of the support into the liquid, preferably submitted to stirring:
- the dragging (displacement) of the support through the liquid;
- the skimming by the support of the surface of the liquid;
- the atomization (nebulization) of the liquid onto the support;
- the immersion of the support into a curtain of liquid;
- the projection onto the support of sprays or jets of liquid.

In the cases of contact of the support with a wave of liquid, the wave may be generated with the same methods already used for producing waves of molten metal in the known "WAVE SOLDERING" processes. In this connection, reference is made to the book Soldering in Electronics, by R.J. Klein Wassink, Electrochemical Publ., 1984.

According to a variant that may be applied to the contact realized by means of a wave or dragging (displacement) as indicated herein above, the liquid perfluoropolyether may be placed as a layer, of a greater or lesser thickness, over a conventional soldering bath consisting of molten metal. In that case it will be possible to immerse the support in such a way that its lower face is in contact with the molten metal while its upper face is immersed in the overlying perfluoropolyether layer.

It will thus be possible to obtain the soldering of the electronic components arranged under the support, by deposition of molten metal, while the soldering of the components arranged on top of the support will be obtained by the binding action of the soldering material that will be promoted by the contact with the perfluoropolyether, heated by the molten metal (and vice versa). In this way the advantages of the two methods are combined, besides which one achieves protection of the metal bath from oxidation.

A practical way for realizing the process according to the present invention may include the following operations in the given order:

(I) Preparation of the support with the components to be soldered, kept in place, in the case of their being positioned on the surface, by a suitable soldering material or, if mounted through metallized holes filled with soldering materials, by means of conventional mechanical devices.

(2) Heating up of the assembly of step (I), for a convenient period of time and at a suitable temperature, in general for I5-20 seconds at between 80° and I00°C, in hot air, in order to remove the low volatile components. The operation may degas and/or partially vulcanize the soldering materials so as to ensure partial fixing of the components on the support in view of the subsequent phases of the process.

(3) Introduction of the supports, from step (2) into a system for the treatment with perfluoropolyether in the liquid state, under the previously described conditions and with the object of developing the binding properties of the soldering material. The present operation may include, besides the soldering, operations of pre-heating and cooling of the assembly in order to minimize the thermal stress on the pieces. A pre-chosen profile of the process temperature may be obtained by introducing the pieces into a sequential system in which the liquid itself is kept at different temperatures and where the pieces are heated with quantities of heat depending on the temperature of the fluid, on the dwell time (permanence time), and on the geometry of the zones. For the purpose there may be used one single device consisting of three liquid baths in which there take place, respectively, the preheating, the soldering, and the cooling of the assembly.

(4) The steps from (l) to (3) may be followed, even if not altogether necessary, by the washing of the assembly by means of a thin film of the same liquid perfluoropolyether, in order to allow recovery of the liquid itself. The dwelling time (permanence time) of the piece, the temperature of the washing liquid, and the distance from which this latter is sprayed onto the assembly, should be chosen in such a way as to optimize the recovery of the liquid and the cooling down of the assembly.

Possibly the assembly may be subjected to washing with a solvent mixable with the liquid, for example l-l-2-trichloro-trifluoroethane or its azeotropes. The solvent and the liquid may then be recovered by distillation and be recycled into the system in their respective locations.

In the particular case in which the components are mounted on the surface of both faces of the support, in order to better ensure the fixing of the components during the soldering phase, before step (3) there may be carried out an additional operation which consists in wrapping the assembly in a suitable film or covering of thermo-shrinkable material, for instance made of a synthetic polymer.

In such a case, the shrinkage of the film on the assembly will ensure the keeping in position of the components.

The operation may be facilitated by operating under conditions of a slight vacuum, for example of 10 Torr. Instead of a thermo-shrinkable film there may be used, for the same purpose, a permeable material, for instance of a textile fibre. In such a case, this operation of wrapping the assembly, may conveniently be carried out after step (l) of the process.

The thermo-shrinkable material is preferably chosen amongst those having a shrinking temperature of between l50 °C and l80 °C, so as to carry out the shrinkage operation on the film simultaneously with the pre-heating of the assembly. If the shrinkage temperature is lower, a suitable heating system, for example by hot air, will allow one to carry out the thermo-shrinking operation before step (3).

When one adopts this technique, the piece coming from step (3) will be washed by a jet of liquid as described under step (4). Thereupon there will be carried out the removal of the film from the assembly, which in its turn will be cleaned according to the usual techniques employed for the removal of possible fluxes.

The following examples are given to further illustrate this invention, but without any intention of limiting in any way the scope of the invention itself.

<u>Example I</u>

On each of four ceramic material supports provided with a palladium-silver metallization, achieved by screen printing using a soldering cream comprising 62 Sn/36 Pb/2 Ag, there was mounted a component (a chip carrier) having 20 connection pins. Each assembly was degassed in air by heating up for l5 minutes at l00 °C. The process was then operated in the following way:

(a) One of the four assemblies was immersed into a 'GALDEN LP' bath kept under stirring (a perfluoropolyether comprised in General Formula (I), of a molecular weight greater than 5000, produced by MONTEFLUOS S.p.A., and having a viscosity at 20 °C of 1000 cSt). The temperature of the bath was 230 °C. Immersion time amounted to 13 s.

(b) Another of the assemblies was passed through a stationary wave of GALDEN LP at a temperature of 235 °C. The travelling speed of the piece through the wave equalled 0.5 cm/s.

(c) A third assembly was kept in contact, with only just its lower face, with the GALDEN LP so as to prevent the liquid from migrating to the upper part of the ceramic support. The temperature of the fluid was 230 °C. The contact time was 22 s.

(d) The fourth assembly was treated as at (c), but with the difference that a thin film of the fluid was allowed to migrate to the upper part of the ceramic support. The temperature was 230 °C. The contact time was 12 s.

In all these cases the soldering was observed to be good. In one case only, during operation (a), the "chip carrier" had shifted from its position. This indicated that preventive degassing of the assemblies would be especially desirable in the case of immersion.

Example 2

In order to keep the components better in position, a series of assemblies of the type described in Example I, with components mounted on both faces, were coated with a film of polyethylene, high-resistance nylon, and polyethylene-terephthalate (P.E.T.), respectively. The films were applied under a light vacuum, and were then heat-shrunk in hot air.

The assemblies were then immersed in a 'GALDEN LP' bath, having a thermostatically controlled temperature of between 220° and 240° C.

The soldering times for the assemblies were only slightly greater than those measured in Example I(a). This shows that all these systems do not hinder in any significant way the heat transfer rate from the perfluoropolyether to the assembly.

The polyethylene film decomposed at melt temperature, though maintaining its integrity for a sufficient time to keep the component firmly in position on the support.

Example 3

A programme similar to that illustrated in Example I was carried out on supports of glass fibre impregnated with epoxy resin of the commercial type, mounting components on its surface and in holes passing through the support, respectively four "dual-in-line packaged IC" components and various discrete components. The devices had been fixed in place with a soldering cream comprising 62 Sn/36 Pb/2Ag. Thereupon degassing was carried out at I00° C for I0 to I5 seconds.

The process then proceeded in the following way:

(a) One assembly was subjected to the same procedure as that described in Example I(a), but with an immersion time of I5 s.

(b) A second assembly was subjected to the same procedure as that of Example I(c), but with a contact time of 42 s.

(c) Still another assembly was subjected to the same procedure as that described in Example I(d), but with a contact time of 25 s.

For comparative purposes, analogous assemblies were kept immersed, at a temperature of 232° C, in saturated vapour of 'GALDEN LS/230' (a perfluoropolyether comprised in formula (I), of a molecular weight of about 800, produced by MONTEFLUOS S.p.A.). The time necessary to obtain melting of the soldering creams proved to amount to 45 seconds.

In all the above cases (a), (b), and (c), the soldering was judged good and no drawbacks of displacements of the components on the support were observed. The heat transfer times from the fluid to the assembly proved, moreover, shorter than those necessary when soldering in vapour phase.

Example 4

A series of tests analogous to those of Example I was carried out using a support mounting conventional components fixed in holes passing through the support itself. Into the metallized holes of the support was applied a soldering paste comprising 62 Sn/36 Pb/2Ag. The temperature of the 'GALDEN LP' bath was 230° C. The assemblies were kept immersed in the fluid for I8 s. The quality of the soldered joints was judged to be good.

In all of Examples I to 4, cleaning of the assemblies after soldering was carried out with a washing system, commercially available on the market, which adopts an ultrasonic bath and I-I-2-trichloro-trifluoroethane. The assemblies were cleaned in all the cases of Examples I to 4, for I minute.

In no cases was there visual evidence of residues of perfluoropolyether on the assemblies. After cleaning, the polluted I-I-2-trichloro-trifluoroethane solvent remaining in the washing apparatus was recovered by separating it by distillation from the perfluoropolyether.

At the end of the tests mentioned in Examples I to 4, the perfluoropolyether remaining in the soldering apparatus, as well as that recovered by distillation from the cleaning solvent, was suitably filtered in order to remove residual particles, various impurities, and gases dissolved therein. The liquid thus obtained did not show, under analysis, any alterations whatsoever of its chemical/physical characteristics.

## Claims

1. A process for soldering electronic components to a support, the process comprising arranging the components on the support together with a soldering material, and then placing the thus obtained assembly in contact with a perfluoropolyether which is in the liquid state and which has a temperature equal to or greater than the temperature at which the soldering material develops its binding properties.

2. A process as claimed in claim I, in which the perfluoropolyether has the general formula:

$$CF_3 - (O-\underset{\displaystyle CF_3}{\underset{|}{CF}} - CF_2)_n-(O - CF_2)_m-O-CF_3$$

   wherein:
   n is a number in the range from 5 to 50; and
   m is a number such that n/m is in the range from I0 to 50.

3. A process as claimed in claim I or 2, in which the contact between the perfluoropolyether and the assembly is achieved through a perfluoropolyether wave that skims the lower surface of the support.

4. A process as claimed in claim I or 2, in which the contact between the perfluoropolyether and the assembly is achieved by passing the support through a perfluoropolyether wave.

5. A process as claimed in claim I or 2, in which the contact between the perfluoropolyether and the assembly is achieved by immersing the support in the perfluoropolyether.

6. A process as claimed in claim I or 2, in which the contact between the perfluoropolyether and the assembly is achieved by displacing the support through the perfluoropolyether.

7. A process as claimed in claim I or 2, in which the contact between the perfluoropolyether and the assembly is achieved by causing the support to skim the surface of a bath of the perfluoropolyether.

8. A process as claimed in claim I or 2, in which the contact between the perfluoropolyether and the assembly is achieved by atomizing the perfluoropolyether onto the support or by ejecting sprays or jets of the perfluoropolyether onto the support.

9. A process as claimed in claim I or 2, in which the contact between the perfluoropolyether and the assembly is achieved by immersing the support in a perfluoropolyether curtain.

10. A process as claimed in any of claims I to 9, in which the support carrying the electronic components and the soldering material, is wrapped, before contact with the perfluoropolyether, in a film of thermo-shrinkable material.

11. A process as claimed in any of claims I to 9, in which the support carrying electronic components and the soldering material, is wrapped, before contact with the perfluoropolyether, in a covering of permeable material.

12. A process as claimed in claim I, 2, 4, 5, or 6, in which the perfluoropolyether is in the form of a layer covering a bath of molten metal.

13. A process as claimed in any of claims I to I2, in which the perfluoropolyether has a molecular weight exceeding 5000.

## Revendications

1. Un procédé pour le soudage de composants électroniques sur un support, procédé consistant à

disposer les composants sur le support en même temps qu'un matériau de soudage, puis à placer le montage ainsi obtenu en contact avec un perfluoropolyéther, qui est à l'état liquide et dont la température est supérieure ou égale à la température à laquelle le matériau de soudage développe ses propriétés de liaison.

2. Un procédé selon la revendication I, dans lequel le perfluoropolyéther a la formule générale suivante:

$$CF_3-(O-\underset{CF_3}{\underset{|}{CF}}-CF_2)_n-(O-CF_2)_m-O-CF_3 \qquad (I)$$

dans laquelle:
n est un nombre compris entre 5 et 50; et
m est un nombre tel que n/m soit compris entre I0 et 50.

3. Un procédé selon la revendication I ou 2, dans lequel le contact entre le perfluoropolyéther et le montage est réalisé par une vague de perfluoropolyéther qui écrème la surface inférieure du support.

4. Un procédé selon la revendication I ou 2, dans lequel le contact entre le perfluoropolyéther et le montage est réalisé par passage du support à travers une vague de perfluoropolyéther.

5. Un procédé selon la revendication I ou 2, dans lequel le contact entre le perfluoropolyéther et le montage est réalisé par immersion du support dans le perfluoropolyéther.

6. Un procédé selon la revendication I ou 2, dans lequel le contact entre le perfluoropolyéther et le montage est réalisé par déplacement du support à travers le perfluoropolyéther.

7. Un procédé selon la revendication I ou 2, dans lequel le contact entre le perfluoropolyéther et le montage est réalisé par écrémage, par le support, de la surface d'un bain du perfluoropolyéther.

8. Un procédé selon la revendication I ou 2, dans lequel le contact entre le perfluoropolyéther et le montage est réalisé par atomisation du perfluoropolyéther sur le support ou par envoi de pulvérisations ou de jets du perfluoropolyéther sur le support.

9. Un procédé selon la revendication I ou 2, dans lequel le contact entre le perfluoropolyéther et le montage est réalisé par immersion du support dans un rideau de perfluoropolyéther.

10. Un procédé selon l'une quelconque des revendications I à 9, dans lequel le support qui porte les composants électroniques et le matériau de soudage est enveloppé, avant contact avec le perfluoropolyéther, dans un film d'un matériau thermorétractable.

11. Un procédé selon l'une quelconque des revendications I à 9, dans lequel le support qui porte les composants électroniques et le matériau de soudage est enveloppé, avant contact avec le perfluoropolyéther, dans une enveloppe en un matériau perméable.

12. Un procédé selon les revendications I, 2, 4, 5 ou 6, dans lequel le perfluoropolyéther se présente sous la forme d'une couche qui recouvre un bain de métal fondu.

13. Un procédé selon l'une quelconque des revendications I à I2, dans lequel le perfluoropolyéther a une masse moléculaire supérieure à 5000.

**Ansprüche**

1. Verfahren zum Löten elektronischer Bauteile an einen Träger, welches umfaßt: Anordnen der Bauteile auf dem Träger zusammen mit einem Lötmaterial und danach in Kontakt Bringen der so erhaltenen Anordnung mit einem Perfluorpolyether, der sich im flüssigen Zustand befindet und eine Temperatur gleich oder größer derjenigen hat, bei der das Lötmittel seine bindenden Eigenschaften entfaltet.

**2.** Verfahren gemäß Anspruch I, in dem der Perfluorpolyether folgende allgemeine Formel hat:

$$CF_3 - (O-\underset{\displaystyle CF_3}{\underset{|}{CF}} - CF_2)_n-(O - CF_2)_m-O-CF_3$$

in welcher n eine Zahl zwischen 5 und 50 ist und m eine solche Zahl, daß n/m zwischen I0 und 50 liegt.

**3.** Verfahren gemäß Anspruch I oder 2, in dem der Kontakt zwischen dem Perfluorpolyether und der Anordnung durch eine Perfluorpolyether-Welle hergestellt wird, die über die untere Oberfläche des Trägers gleitet.

**4.** Verfahren gemäß Anspruch I oder 2, in dem der Kontakt zwischen dem Perfluorpolyether und der Anordnung dadurch hergestellt wird, daß der Träger durch eine Perfluorpolyether-Welle hindurchgeleitet wird.

**5.** Verfahren gemäß Anspruch I oder 2, in dem der Kontakt zwischen dem Perfluorpolyether und der Anordnung durch Eintauchen des Trägers in den Perfluorpolyether hergestellt wird.

**6.** Verfahren gemäß Anspruch I oder 2, in dem der Kontakt zwischen dem Perfluorpolyether und der Anordnung durch Ziehen des Trägers durch den Perfluorpolyether hergestellt wird.

**7.** Verfahren gemäß Anspruch I oder 2, in dem der Kontakt zwischen dem Perfluorpolyether und der Anordnung hergestellt wird, indem man den Träger über die Oberfläche eines Perfluorpolyether-Bades gleiten läßt.

**8.** Verfahren gemäß Anspruch I oder 2, in dem der Kontakt zwischen dem Perfluorpolyether und der Anordnung durch Feinzerstäuben des Perfluorpolyethers auf den Träger oder durch Drucksprayen oder Aufspritzen des Perfluorpolyethers auf den Träger hergestellt wird.

**9.** Verfahren gemäß Anspruch I oder 2, in dem der Kontakt zwischen dem Perfluorpolyether und der Anordnung durch Eintauchen des Trägers in einen Perfluorpolyether-Vorhang hergestellt wird.

**10.** Verfahren nach irgendeinem der Anspruche I bis 9, in dem der Träger, auf dem sich die elektronischen Bauteile befinden, in eine wärmeschrumpfbare Folie eingeschlagen wird, bevor er mit dem Perfluorpolyether in Kontakt gebracht wird.

**11.** Verfahren nach irgendeinem der Ansprüche I bis 9, in dem der Träger, auf dem sich die elektronischen Bauteile befinden, in eine Umhüllung aus durchlässigem Material eingeschlagen wird, bevor er mit dem Perfluorpolyether in Kontakt gebracht wird.

**12.** Verfahren gemäß den Ansprüchen I, 2, 4, 5 oder 6, in dem der Perfluorpolyether in Form einer Schicht vorliegt, die ein Bad aus geschmolzenem Metall bedeckt.

**13.** Verfahren gemäß irgendeinem der Ansprüche I bis I2, in dem der Perfluorpolyether ein Molekulargewicht von über 5000 besitzt.